Europäisches Patentamt

European Patent Office

Office européen des brevets

(11) Veröffentlichungsnummer : **0 039 941**
**B1**

(12) **EUROPÄISCHE PATENTSCHRIFT**

(45) Veröffentlichungstag der Patentschrift :
20.08.86

(51) Int. Cl.⁴ : **H 01 L 29/743, H 01 L 29/91,
H 01 L 29/08, H 01 L 29/52**

(21) Anmeldenummer : **81103601.1**

(22) Anmeldetag : **11.05.81**

(54) **Schaltung zum Betrieb eines Halbleiterbauelements.**

(30) Priorität : **14.05.80 DE 3018499**

(43) Veröffentlichungstag der Anmeldung :
**18.11.81 Patentblatt 81/46**

(45) Bekanntmachung des Hinweises auf die Patenterteilung : **20.08.86 Patentblatt 86/34**

(84) Benannte Vertragsstaaten :
**CH FR GB IT LI NL SE**

(56) Entgegenhaltungen :
**EP-A- 0 008 008
DE-B- 2 625 917**

(73) Patentinhaber : **Siemens Aktiengesellschaft Berlin
und München
Wittelsbacherplatz 2
D-8000 München 2 (DE)**

(72) Erfinder : **Patalong, Hubert, Dr.
Kurt-Flöricke-Strasse 1
D-8000 München 60 (DE)**

**Beschreibung**

Die Erfindung bezieht sich auf eine Schaltung zum Betrieb eines Halbleiterbauelements nach dem ersten Teil des Patentanspruchs 1.

Eine solche Schaltung, die zum Betrieb eines Thyristors dient, ist aus der DE-B2-2 625 917 bekannt. Wie aus den Figuren 4 und 4a hervorgeht, ist die Gateelektrode hier über einen Schalttransistor mit dem von der Emitterschicht abgewandten Anschluß eines in Serie zum Kathodenanschluß in den äußeren Stromkreis eingefügten Lastelements verbunden. Der genannte Schalttransistor wird im blockierten Zustand des Thyristors durch einen Triggerimpuls leitend geschaltet, um eine Zündung desselben zu bewirken. Dabei wird der Gateelektrode über den Schalttransistor die Spannung einer im äußeren Stromkreis vorgesehenen Spannungsquelle zugeführt, wodurch ein über die Gateelektrode steuerbarer Emitterkurzschluß unwirksam geschaltet wird. Eine Beeinflussung der Gateelektrode durch eine am Lastelement anliegende Spannung ist aber nur beim Auftreten eines Triggerimpulsees, d. h. nur zum Zeitpunkt einer gewünschten Zündung des Thyristors, möglich.

Aus der US-PS 3 243 669 ist ein Bauelement der im ersten Teil des Patentanspruchs 1 erwähnten Art bekannt, das sich bei einer zwischen Anode und Kathode anliegenden, in Durchlaßrichtung gepolten Spannung entweder in einem ersten Schaltzustand befindet, in dem es niederohmig und stromführend ist, oder in einem zweiten Schaltzustand, der auch als blockierter Zustand bezeichnet wird, in dem zwischen Anode und Kathode praktisch kein Strom fließt. Die MIS-Struktur besteht hierbei aus einer neben der P-Emitterschicht angeordneten, von der Grenzfläche ausgehenden p-leitenden Zone, aus dem randseitigen Teil der P-Emitterschicht und aus einer die Grenzfläche zwischen diesen beiden Teilen isoliert überdeckenden Gateelektrode, wobei die P-leitende Zone in die N-Basisschicht eingebettet und durch eine auf der Grenzfläche angeordnete leitende Belegung mit der N-Basisschicht verbunden ist. Beim Anlegen einer Steuerspannung an die Gateelektrode wird ein Kurzschlußpfad wirksam geschaltet, der den PN-Übergang zwischen der mit der Anode verbunden P-Emitterschicht und der angrenzenden N-Basisschicht überbrückt. Das hat eine Umschaltung aus dem stromführenden Zustand in den blockierten Zustand zur Folge. Der Übergang aus dem blockierten in den stromführenden Zustand erfolgt durch eine Überbrückung des PN-Übergangs zwischen der P-Basisschicht und der N-Basisschicht mittels einer weiteren mit einer Gateelektrode versehenen MIS-Struktur.

Aus der DE-AS 2 438 894 ist es andererseits bekannt, ein als Thyristor ausgebildetes Halbleiterbauelement mit festen Emitterkurzschlüssen zu versehen, die aus Ansätzen der P-Basisschicht bestehen, welche mit der Kathode leitend verbunden sind. Diese bewirken eine gute Stabilisierung des Bauelements, d. h. eine große Sicherheit gegen unbeabsichtigte Zündvorgänge beim Auftreten von in Durchlaßrichtung gepolten Spannungen an der Anoden-Kathodenstrecke, die teilweise sehr schnell ansteigen (hohe dU/dt-Belastungen).

Nachteilig ist es, daß die wegen einer guten Stabilisierung notwendigen Emitterkurzschlüsse leicht zu thermischen Überlastungen des Thyristors bei gewollten oder ungewollten Zündvorgängen führen. Beim Übergang aus dem blockierten Zustand in den stromführenden Zustand bildet sich nämlich zunächst ein sehr dünner Strompfad zwischen Anode und Kathode aus, der sich dann anschließend verbreitert, bis der ganze Querschnitt des Thyristors stromführend geworden ist. Die Ausbreitungsgeschwindigkeit des Randes der jeweils stromführenden Fläche, gemessen in der die N-Emitterschicht oder P-Emitterschicht enthaltenden Grenzfläche, beträgt bei mit Emitterkurzschlüssen versehenen Thyristoren nur etwa 0,01 bis 0,1 mm/$\mu$s. Das führt aber zu hohen Einschaltverlusten und damit zu einer niedrigen Strombelastbarkeit.

Der Erfindung liegt die Aufgabe zugrunde, eine Schaltung der eingangs genannten Art anzugeben, die für das Halbleiterbauelement einerseits eine gute Stabilität und andererseits eine große Zündausbreitungsgeschwindigkeit und damit eine große Strombelastbarkeit gewährleistet. Diese Aufgabe wird durch die im Patentanspruch 1 gekennzeichneten Merkmale gelöst.

Der mit der Erfindung erzielbare Vorteil liegt insbesondere darin, daß der beabsichtigte oder beim Auftreten einer hohen Blockierspannung erfolgende, unbeabsichtigte Übergang vom blockierten Zustand in den stromführenden Zustand wesentlich schneller vollzogen wird als bei den bekannten Bauelementen. Durch die Ansteuerung der Gateelektrode (n) der MIS-Struktur(en) über den in Serie zum Kathodenanschluß (Anodenanschluß) liegenden Widerstand erfolgt eine selbsttätige Aufhebung der durch die MIS-Strukturen gebildeten Emitterkurzschlüsse in Abhängigkeit von dem das Bauelement durchfließenden Laststrom. Damit wird die bei hohen Lastströmen zunächst sehr hohe Energiedichte im zuerst gezündeten Halbleitergebiet wesentlich schneller als bei den herkömmlichen Bauelementen dieser Art auf einen Wert abgesenkt, der im vollgezündeten Zustand des Bauelements vorhanden ist.

Die Patentansprüche 2 bis 5 geben vorteilhafte Ausgestaltungen und Weiterbildungen der Erfindung an.

Die Erfindung wird nachfolgend anhand der Zeichnung näher erläutert. Dabei zeigt :

Figur 1 ein erstes Ausführungsbeispiel der Erfindung,

Figur 2 eine Weiterbildung des ersten Ausführungsbeispiels,

Figur 3 ein Zweites Ausführungsbeispiel,
Figur 4 ein drittes Ausführungsbeispiel und
Figur 5 ein viertes Ausführungsbeispiel.

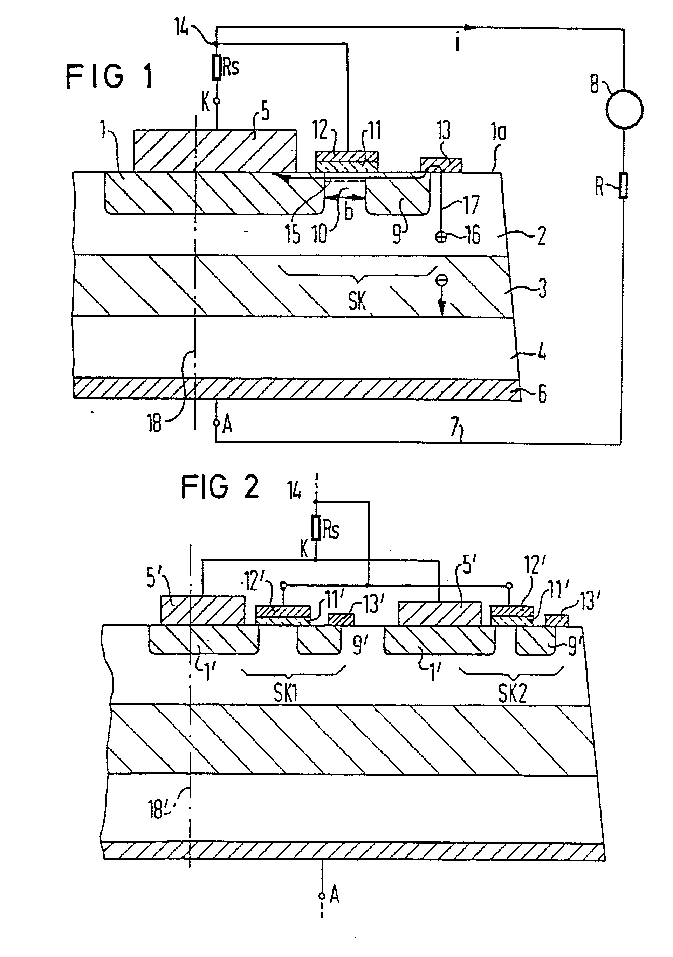

Das in Figur 1 dargestellte Halbleiterbauelement besteht aus einem Halbleiterkörper, z. B. aus Si, mit vier Schichten abwechselnder Leitfähigkeitstypen. Dabei wird die außenliegende, N-leitende Schicht 1 als N-Emitterschicht bezeichnet, die außenliegende, P-leitende Schicht 4 als P-Emitterschicht. Die P-leitende Schicht 2 stellt dann die sogenannte P-Basisschicht dar, während die M-leitende Schicht 5 als N-Basisschicht bezeichnet wird. Die N-Emitterschicht 1 ist mit einer Kathode 5 versehen, die einen Anschluß K aufweist, während die P-Emitterschicht 4 mit einer Anode 6 kontaktiert ist, deren Anschluß mit A bezeichnet ist. An die Anschlüsse A und K ist ein äußerer Stromkreis 7 mit einem Lastwiderstand R und einer Gleich- oder Wechselspannungsquelle 8 angeschlossen.

Neben der N-Emitterschicht 1 ist eine in die P-Basisschicht 2 eingebettete N-leitende Zone 9 vorgesehen, die sich bis zur Grenzfläche 1a des Halbleiterkörpers erstreckt. Zwischen ihr und dem rechten Rand der N-Emitter-zone 1 liegt eine P-Zwischenschicht 10 mit der Breite b, die aus einem Teil der P-Basisschicht 2 besteht. Die Grenzfläche 1a wird oberhalb der P-Zwischenschicht 10 von einer dünnen elektrisch isolierenden Schicht 11 abgedeckt. Auf dieser befindet sich eine Gateelektrode 12, beispielsweise aus Aluminium oder hoch dotiertem polykristallinen Silizium. Der PN-Übergang zwischen der Zone 9 und der P-Basisschicht 2 wird durch eine leitende Belegung 13 überbrückt. In den äußeren Stromkreis 7 ist in Serie zum Kathodenanschluß K ein Widerstand Rs eingefügt, dessen von der Kathode 5 abgewandter Anschluß 14 mit der Gateelektrode 12 verbunden ist.

Die N-leitenden Halbleiterteile 1 und 9 stellen zusammen mit der P-Zwischenschicht 10 und der auf die isolierende Schicht 11 aufgebrachten Gateelektrode 12 eine MIS-Struktur des Verarmungstyps dar. Das bedeutet, daß bei gleichem Potential der Kathode 5 und der Gateelektrode 12 ein N-leitender Inversionskanal 15 an der Grenzfläche 1a im Bereich der P-Zwischenschicht 10 besteht. Unter dem Einfluß einer von 8 aufgebrachten Blockierspannung zwischen A und K, bei der die Anode auf einem höheren Potential liegt als die Kathode, ergibt sich für die positiven Ladungsträger 16 aus der P-Basisschicht 2 ein mit 17 bezeichneter Kurzschlußpfad, der über die Teile 13, 9, 15 und 1 zur Kathode 5 verläuft. Dieser Kurzschlußpfad 17 stellt einen steuerbaren Emitterkurzschluß SK dar, der den Inversionskanal 15 als eigentliche Schaltstrecke enthält. Von dem Vorhandensein oder Nichtvorhandensein des Inversionskanals 15 hängt es ab, ob der Emitterkurzschluß 17 wirksam geschaltet ist oder nicht.

Im blockierten Zustand des in Figur 1 dargestellten Halbleiterbauelements, das auch als Shockley-Diode bezeichnet wird, ist der Kurzschlußpfad 17 wegen des vorhandenen Inversionskanals 15 wirksam geschaltet und verhindert eine Zündung bis zu hohen Blockierspannungen. Erst beim Erreichen der Durchbruchspannung bildet sich ein Strompfad zwischen der Kathode 5 und der Anode 6 aus, in dem positive Ladungsträger 16 aus der P-Basisschicht 2 zum PN-Übergang zwischen den Schichten 1 und 2 gelangen und dort eine Injektion negativer Ladungsträger aus der Schicht 1 in die Schicht 2 hervorrufen. Gleichzeitig werden Elektronen beim Aufbau der Raumladungszone zwischen den Schichten 2 und 3 aus der N-Basis in den P-Emitter verdrängt und bewirken dort eine Injektion von Defektelektronen. Der hierbei entstehende Laststrom i läßt an Rs eine Spannung abfallen, die die Gateelektrode 12 gegen die Kathode 5 negativ vorspannt. Hierdurch wird aber der N-leitende Inversionskanal 15 beseitigt, so daß bei unwirksam geschaltetem Emitterkurzschluß eine sehr schnelle Ausbreitung der stromführenden bzw. gezündeten Fläche in lateraler Richtung über den ganzen Querschnitt des Bauelements erfolgt. Die Abschaltung des im blockierten Zustand aus Stabilisierungsgründen vorhandenen Emitterkurzschlusses geschieht also selbsttätig in Abhängigkeit von dem beim Übergang aus dem blockierten in den stromführenden Zustand einsetzenden Laststrom i. Damit werden die Energiedichten, die in den den Halbleiterkörper durchsetzenden Strompfaden bei einsetzendem Laststrom i hervorgerufen werden, praktisch sofort auf jene Werte abgesenkt, die bei einer Ausdehnung der gezündeten Fläche auf den ganzen Querschnitt des Halbleiterkörpers vorliegen.

Die N-Emitterschicht 1 und die N-leitende Zone 9 können langgestreckt ausgebildet sein, wobei ihre größeren Abmessungen senkrecht zur Bildebene von Figur 1 liegen. Die Teile 5, 11, 12 und 13 sind dann zweckmäßigerweise ebenfalls langgestreckt ausgebildet, so daß sie praktisch über die ganze Grenzfläche 1a verlaufen. Dabei kann der Aufbau symmetrisch zu einer Ebene sein, die zur Bildebene von Figur 1 senkrecht steht und durch die Linie 18 angedeutet ist. In diesem Fall ist links von der Linie 18 ein weiterer steuerbarer Emitterkurzschluß vorgesehen, dessen Gateelektrode ebenfalls mit dem Anschluß 14 verbunden ist. Andererseits ist auch ein rotationssymmetrischer Aufbau des Halbleiterbauelements nach Figur 1 mit der Linie 18 als Symmetrieachse vorteilhaft. Dabei sind die Teile 1 bis 5 kreisförmig ausgebildet, während die Teile 9, 11, 12 und 13 kreisringförmig ausgebildet und zu den Teilen 1 bis 5 konzentrisch angeordnet sind.

Figur 2 zeigt eine Weiterbildung des Halbleiterbauelements nach Figur 1, bei der die N-Emitterschicht 1 in zwei N-Emitterzonen 1' aufgeteilt ist. Neben jeder derselben ist eine N-leitende Zone 9' vorgesehen, die mittels der bereits anhand der Figur 1 beschriebenen Teile 11' bis 13' zu steuerbaren Emitterkurzschlüssen SK1 und SK2 ergänzt werden. Jeder dieser Kurzschlüsse arbeitet in der bereits beschriebenen Weise. Auch hier kann die Linie 18 wieder als Symmetrieebene oder als Symmetrieachse aufgefaßt werden. Anstelle der beiden in Figur 2 dargestellten N-Emitterzonen können auch mehrere vorgesehen sein.

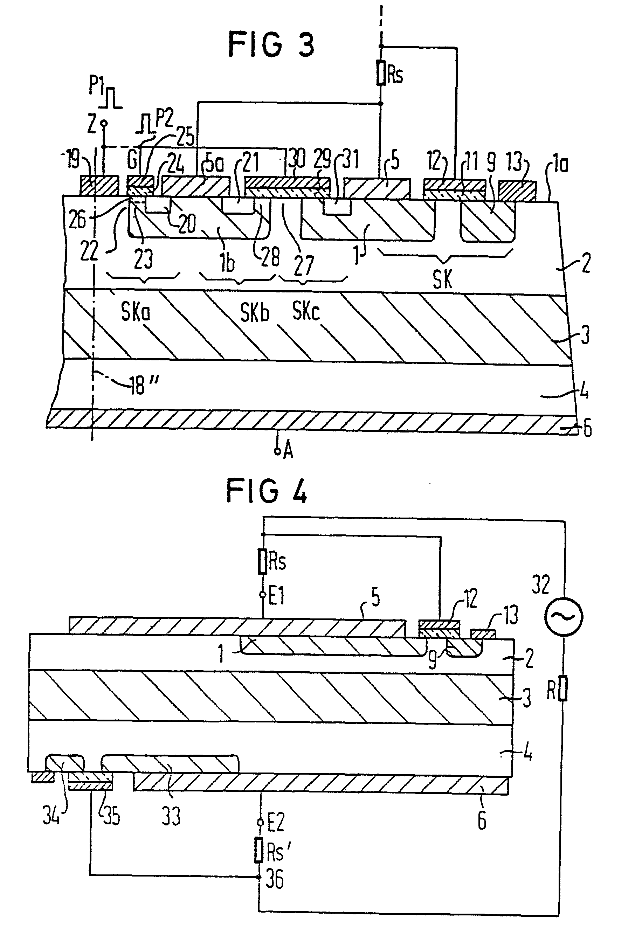

Das in Figur 3 dargestellte Ausführungsbeispiel weist neben den bereits anhand von Figur 1 beschriebenen, mit den gleichen Bezugszeichen versehenen Schaltungsteilen eine Zündelektrode 19 auf, die auf der P-Basisschicht 2 angeordnet ist und einen Anschluß Z für einen Zündstromkreis besitzt. Damit handelt es sich bei diesem Ausführungsbeispiel um einen Thyristor. In eine zusätzliche N-Emitterzone 1b sind P-leitende Halbleitergebeite 20 und 21 eingefügt, die sich bis zur Grenzfläche 1a erstrecken und in dieser ebenso wie die Zone 1b mit einem Kathodenteil 5a kontaktiert sind. Der Kathodenteil 5a ist seinerseits mit der Kathode 5 leitend verbunden. Das Halbleitergebiet 20 bildet zusammen mit dem Teil 22 der P-Basisschicht und dem Teil 23 der Zone 1b eine laterake PNP-Struktur, die durch eine dünne Isolierschicht 24 und eine den Teil 23 isoliert überdeckende Gateelektrode 25 zu einer MIS-Struktur des Verarmungstyps ergänzt wird. Ohne Zuführung einer Spannung an den Steuerspannungsanschluß G der Gateelektrode 25 ist in dem Teil 23 der Zone 1b ein die Teile 20 und 22 miteinander verbindender Inversionskanal 26 vorhanden. Da das Gebiet 20 mit dem Kathodenteil 5a verbunden ist, ergibt sich ein über G steuerbarer Emitterkurzschluß SKa, der bei vorhandenem Inversionskanal 26 den PN-Übergang zwischen der Zone 1b und der P-Basisschicht 2 überbrückt. In analoger Weise bilden das Gebiet 21, der Teil 27 der P-Basisschicht 2 und der Teil 28 der Zone 1b eine weitere PNP-Struktur, die durch eine auf einer Isolierschicht 29 aufgebrachte, mit dem Anschluß G verbundene Gateelektrode zu einem weiteren Emitterkurzschluß SKb ergänzt wird. Mittels eines in die N-Emitterschicht 1 eingebrachten, P-leitenden Halbleitergebiets 31 und der nach rechts verlängerten Teile 29 und 30 ist schließlich noch ein weiterer Emitterkurzschluß SKc aufgebaut.

Die bei spannungslosem Anschluß G wirksam geschalteten Emitter-Kurzschlüsse SKa bis SKc stabilisieren den Thyristor zusammen mit dem ebenfalls wirksam geschalteten Emitterkurzschluß SK gegenüber hohen Blockierspannungen. Bei Zuführung eines Zündimpulses P1 an Z erfolgt die Zündung. Gleichzeitig mit P1 wird ein positiver Impuls P2 an G gelegt, der die Abschaltung von SKa bis SKc bewirkt.

Diese Abschaltung hat eine schnelle Ausbreitung der gezündeten Fläche in lateraler Richtung über den Querschnitt des Thyristors zur Folge. Mit dem Ansteigen des Laststroms i durch den Widerstand Rs wird aber auch der Emitterkurzschluß SK unwirksam geschaltet, so daß die schnelle Ausbreitung der gezündeten Fläche auch hierdurch gefördert wird. Dabei ist zu beachten, daß die Ansteuerung von SKa bis SKc über einen dem Anschluß G zugeführten Impuls P2 erfolgt, die Ansteuerung von SK jedoch selbsttätig über den Spannungsabfall an Rs. Das bedeutet, daß auch bei ungewollten Zündvorgängen, also ohne eine entsprechende Ansteuerung von Z und G, die Unwirksamschaltung von SK eine schnelle großflächige Zündung bewirkt, welche den Thyristor vor thermischer Zerstörung schützt. Ein solcher Thyristor ist auch über Kopf zündbar, ohne daß er zerstört wird, so daß keine spannungsbegrenzenden Elemente parallel zu ihm vorgesehen werden brauchen. Es kann im übrigen zweckmäßig sein, den Anschluß G mit dem Anschluß Z zu verbinden. In diesem Fall wird der infolge des Zündimpulses P1 an Z auftretende Zündspannungsimpuls zur Ansteuerung von P ausgenutzt. Die Linie 18″ kann wieder als Spur einer Symmetrieebene oder als Symmetrieachse aufgefaßt werden.

In Figur 4 ist ein auch als Diac bezeichnetes Halbleiterbauelement dargestellt, das einer Antiparallelschaltung zweier Bauelemente nach Figur 1 entspricht. Der rechte Teil entspricht dabei der Anordnung nach Figur 1, wobei lediglich die Anschlüsse A und K nunmehr mit E1 und E2 bezeichnet werden. Mit 32 ist eine Wechselspannungsquelle bezeichnet. In Serie zum Anschluß E2 liegt ein Widerstand Rs′, der dem Widerstand Rs entspricht. Für das links dargestellte Antisystem stellt die verlängerte P-Basisschicht 2 die P-Emitterschicht dar, die verlängerte Schicht 3 die N-Basisschicht und die verlängerte Schicht 4 die P-Basisschicht, wobei in die letztere eine N-Emitterschicht 33 und eine N-leitende Zone 34 eingefügt sind.

Die Kathode 5 des rechten Systems stellt gleichzeitig die Anode des linken Systems dar, die Anode 6 des rechten Systems gleichzeitig die Kathode des linken. Die Gateelektrode 35 des rechten Systems ist mit dem von 6 abgewandten Anschluß 36 des Widerstands Rs′ verbunden. Bei dem Bauelement nach Figur 4 verhält sich das rechte System für die eine Halbwelle der von 32 abgegebenen Wechselspannung wie eine Anordnung nach Figur 1, die mit in Durchlaßrichtung gepolten Spannungen beaufschlagt ist, während das linke System beim Auftreten der anderen Halbwelle in entsprechender Weise arbeitet. In beiden Halbwelle tritt eine sehr rasche Ausbreitung der zunächst gezündeten Fläche über den ganzen Querschnitt des jeweiligen Systems ein.

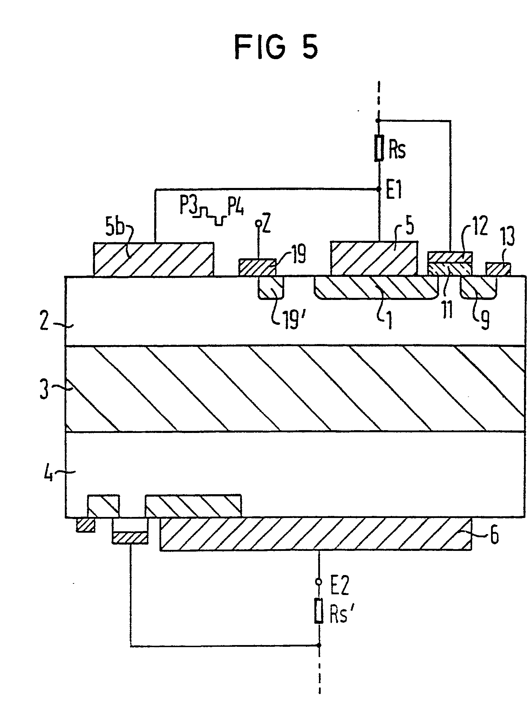

Das in Figur 5 gezeigte Ausführungsbeispiel stellt ein Triac dar, das aus einer Antiparallelschaltung zweier Bauelemente nach Figur 3 gebildet ist. Das rechte System entspricht wieder der Anordnung nach Figur 3, wobei zur Vereinfachung die Zone 1b und die Teile 5a, 24, 25 und 29 bis 31 weggelassen sind. Unterhalb eines Teiles der Zündelektrode 19 befindet sich ein N-leitendes Gebiet 19′ in der P-Basisschicht 2. Der Aufbau des Bauelements nach Figur 5 entspricht der Figur 4 mit dem Unterschied, daß die obere Elektrode 5 von Figur 4 in zwei miteinander leitend verbundene Teile 5 und 5b aufgeteilt ist, zwischen denen sich die Zündelektrode 19 befindet. Das rechte System von Figur 5 arbeitet während der einen Halbwelle einer auch hier entsprechend Figur 4 angeschalteten Wechselspannungsquelle 32 in der gleichen Weise wie der Thyristor nach Figur 3 unter dem Einfluß von in Durchlaßrichtung gepolten Spannungen, wobei auch hier die Einschalthife durch die steuerbaren Emitterkurzschlüsse SKa bis SKc eingesetzt werden könnte, während das linke System von Figur 5 während der anderen Halbwelle in entsprechender Weise funktioniert. Die Ansteuerung der Zündelektrode 19 geschieht mit Impulsen P3, P4 unterschiedlicher Polarität, wobei P3 dem Impuls P1 für das rechte System und P4 dem Impuls P1 für das linke System entsprechen.

Im Rahmen der Erfindung kann auch jeweils die P-Emitterschicht 4 anstelle der N-Emitterschicht 1 durch einen oder mehrere steuerbare Emitterkurzschlüsse SK überbrückt werden. Die Figuren 1 bis 5 können zur Darstellung dieser Schaltungsvariante herangezogen werden, wenn die Bezeichnungen der Anschlüsse A und K miteinander vertauscht werden und die Halbleiterteile 1 bis 4, 9, 20, 21, 31, 33 und 34 die jeweils entgegengesetzten Leitfähigkeitstypen erhalten. Die Impulse P1 bis P4 besitzen dabei jeweils die entgegengesetzten Polaritäten.

**Patentansprüche**

1. Schaltung zum Betrieb eines Halbleiterbauelements mit einem vier Schichten abwechselnder Leitfähigkeitstypen aufweisenden Halbleiterkörper, bei dem eine außenliegende, mit einer Kathode (5) versehene N-Emitterschicht (1), eine außenliegende, mit einer Anode (6) versehene P-Emitterschicht (4) und zwei an diese jeweils angrenzende Basisschichten (2, 3) vorgesehen sind, bei dem die Anode (6) und Kathode (5) jeweils Anschlüsse (A, K) für einen äußeren Stromkreis (7) aufweisen, der ein Lastelement und eine Gleich- oder Wechselspannungsquelle (8, 32) enthält, und bei dem neben einer der Emitterschichten (1) eine MIS-Struktur des Verarmungstyps angeordnet ist, die einen steuerbaren Emitterkurzschluß darstellt und aus dem randseitigen Teil der Emitterschicht (1), aus einer neben derselben angeordneten, von der Grenzfläche (1a) des Halbleiterkörpers ausgehenden Zone (9), die denselben Leitfähigkeitstyp aufweist wie die Emitterschicht (1), und aus einer die Grenzfläche zwischen dieser Emitterschicht (1) und der Zone (9) isoliert überdeckenden Gateelektrode (12) besteht, wobei die Zone (9) mit der angrenzenden Basisschicht (2) leitend verbunden ist und wobei das Lastelement in Serie zu einem der genannten Anschlüsse (K) für den äußeren Stromkreis (7) liegt und einen von der zuletzt genannten Emitterschicht (1) abgewandten Anschluß (14) aufweist, der mit der Gateelektrode (12) beschaltet ist, dadurch gekennzeichnet, daß das Lastelement aus einem Widerstand (Rs) besteht und daß die Gateelektrode (12) mit dem von der Emitterschicht (1) abgewandten Anschluß (14) des Widerstands (Rs) direkt verbunden ist.

2. Schaltung nach Anspruch 1, dadurch gekennzeichnet, daß im Halbleiterbauelement eine der Emitterschichten (1) in mehrere Emitterzonen (1') aufgeteilt ist, neben denen jeweils als steuerbare Kurzschlüsse (SK1, SK2) dienende MIS-Strukturen angeordnet sind, deren Gateelektroden (12') mit dem von den Emitterzonen (1') abgewandten Anschluß (14) des Witerstandes (Rs) verbunden sind.

3. Schaltung nach einem der vorhengehenden Ansprüche, dadurch gekennzeichnet, daß im Halbleiterbauelement eine der Basisschichten mit einer Zündelektrode (19) versehen ist.

4. Schaltung nach einem der Ansprüche 1 bis 3, dadurch gekennzeichnet, daß das Halbleiterbauelement zu einem zweiten, gleichartig aufgebauten antiparallel geschaltet ist (Fig. 4, Fig. 5).

5. Schaltung nach einem der vorhergehenden Ansprüche, dadurch gekennzeichnet, daß im Halbleiterbauelement neben einer mit einer MIS-Struktur versehenen Emitterschicht (1) oder Emitterzone (1b) wenigstens eine weitere MIS-Struktur angeordnet ist, die mit einer gegen die Grenzfläche (1a) des Halbleiterkörpers isolierten Gateelektrode (25) versehen ist und einen steuerbaren Kurzschluß (SKa) darstellt, wobei die Gateelektrode (25) mit einem Steuerspannungsanschluß (G) versehen ist, der gegebenenfalls mit der Zündelektrode (19) verbunden ist.

**Claims**

1. A circuit for operating a semiconductor component with a semiconductor body having four layers of alternating conductivity types, in which there are arranged an external N-emitter layer (1) which is provided with a cathode (5), an external P-emitter layer (4) which is provided with an anode (6), and two base layers (2, 3) which are adjacent to respective emitter layers, in which the anode (6) and cathode (5) respectively possess terminals (A, K) for an external circuit (7) which comprises a load element and a d.c. or a.c. voltage source (8, 32), and in which an MIS-Structure of the depletion type is arranged beside one of the emitter layers (1), which MIS-structure constitutes a controllable emitter short-circuit and consists of the edge-part of the emitter layer (1), of a zone (9) which is arranged beside the latter and extends from the boundary surface (1a) of the semiconductor body and which has the same conductivity type as the emitter layer (1), and of a gate electrode (12) which covers the boundary surface between the emitter layer (1) and the zone (9) in insulated manner, where the zone (9) is conductively connected to the adjoining base layer (2) and where the load element is connected in series to one of said terminals (K) for the external circuit (7) and has a terminal (14) which is remote from the emitter layer (1) and is connected to the gate electrode (12), characterised in that the load element consists of a resistor (Rs) and that the gate electrode (12) is directly connected to the terminal (14) of the resistor (Rs) remote from the emitter layer (1).

2. A circuit as claimed in Claim 1, characterised in that in the semiconductor component, one of the emitter layers (1) is divided into a plurality of emitter zones (1'), beside which MIS-structures which respectively serve as controllable short-circuits (SK1, SK2) are arranged and the gate electrodes (12') of which are connected to the terminal (14) of the resistor (Rs) remote from the emitter zones (1').

3. A circuit as claimed in one of the preceding Claims, characterised in that in the semiconductor component, one of the base layers is provided with an ignition electrode (19).

4. A circuit as claimed in one of Claims 1 to 3, characterised in that the semiconductor component is connected in antiparallel manner to a second, similarly constructed component (Fig. 4, Fig. 5).

5. A circuit as claimed in one of the preceding Claims, characterised in that in the semiconductor component, at least one further MIS-structure is arranged beside an emitter layer (1) or emitter zone (1b) which is provided with an MIS-structure, which further MIS-structure is provided with a gate electrode (25), which is insulated from the boundary surface (1a) of the semiconductor body, and constitutes a controllable short-circuit (SKa), where the gate electrode (25) is provided with a control voltage terminal (G) which is connected to the ignition electrode (19) if necessary.

## Revendications

1. Circuit pour faire fonctionner un composant à semiconducteurs comportant un corps semiconducteur comportant quatre couches possédant des types de conductivité alternés, et dans lequel il est prévu une couche extérieure d'émetteur de type N (1) munie d'une cathode (5), une couche extérieure d'émetteur de type P(4) munie d'une anode (6) et deux couches de base (2, 3) jouxtant respectivement ces couches, et dans lequel l'anode (6) et la cathode (5) possèdent respectivement des bornes (A, K) pour un circuit extérieur (7) qui contient un élément de charge et une source de tension continue ou alternative (8, 32), et dans lequel il est prévu, à côté de l'une des couches d'émetteur (1), une structure MIS du type à appauvrissement qui représente un court-circuit d'émetteur, pouvant être commandé, et est constituée par la partie marginale de la couche d'émetteur (1), par une zone (9) disposée à côté de cette couche et partant de la surface limite (1a) du corps semiconducteur et qui possède le même type de conductivité que la couche d'émetteur (1), et par une électrode de grille (12) recouvrant, de façon isolée, la surface limite entre cette couche d'émetteur (1) et la zone (9), la zone (9) étant reliée de façon conductrice à la couche de base contiguë (2), tandis que l'élément de charge est branché en série avec l'une desdites bornes (K) pour le circuit extérieur (16) et comporte une borne (14), qui est située à l'opposé de la couche d'émetteur (1) indiquée en dernier lieu et qui est raccordée à l'électrode de grille (12), caractérisé par le fait que l'élément de charge est constitué par une résistance (Rs) et que l'électrode de grille (12) est reliée directement à la borne (14), tournée à l'opposé de la couche d'émetteur (1), de la résistance (Rs).

2. Circuit suivant la revendication 1, caractérisé par le fait que dans le composant à semiconducteurs, l'une des couches d'émetteur (1) est subdivisée en plusieurs zones d'émetteur (1'), à côté desquelles se trouvent disposées des structures MIS servant respectivement de courts-circuits (SK1, SK2) pouvant être commandés et dont les électrodes de grille (12') sont reliées à la borne (14), située à l'opposé des zones d'émetteur (1') de la résistance (Rs).

3. Circuit suivant l'une des revendications précédentes, caractérisé par le fait que dans le composant à semiconducteurs, l'une des couches de base est munie d'une électrode d'amorçage (19).

4. Circuit suivant l'une des revendications 1 à 3, caractérisé par le fait que le composant à semiconducteurs est raccordé selon un montage antiparallèle à un second composant à semiconducteurs de constitution identique (figure 4, figure 5).

5. Circuit suivant l'une des revendications précédentes, caractérisé par le fait que dans le composant à semiconducteurs, à côté d'une couche d'émetteur (1) ou d'une zone d'émetteur (1b), munie d'une structure MIS, se trouve disposée au moins une autre structure MIS qui est munie d'une électrode de grille (25) isolée par rapport à la surface limite (1a) du corps semiconducteur et forme un court-circuit (SKa) pouvant être commandé, l'électrode de grille (25) étant munie d'une borne (G) d'application d'une tension de commande, qui est également reliée à l'électrode d'amorçage (19).

FIG 1

FIG 2

# FIG 3

# FIG 4

# FIG 5